# EUROPÄISCHE PATENTSCHRIFT

(11) **EP 2 694 446 B1**
(45) Veröffentlichungstag und Bekanntmachung des Hinweises auf die Patenterteilung: **04.03.2015**
(21) Anmeldenummer: 12726341.6
(22) Anmeldetag: 02.04.2012
(51) Int. Cl.: C03B 33/023, C03B 33/033, C03B 33/037, C03B 33/03

(54) **VORRICHTUNG UND VERFAHREN ZUM ABLÄNGEN EINES FLOAT-GLAS-BANDES MIT NORMALER ODER STRUKTURIERTER OBERFLÄCHE**
DEVICE AND METHOD FOR TRIMMING A FLOAT GLASS STRIP THAT HAS A NORMAL OR STRUCTURED SURFACE
DISPOSITIF ET PROCÉDÉ POUR COUPER À LA LONGUEUR UNE BANDE DE VERRE FLOTTÉ PRÉSENTANT DES SURFACES NORMALES OU STRUCTURÉES

(30) Priorität: 06.04.2011 DE 102011016210
(43) Veröffentlichungstag der Anmeldung: 12.02.2014
(73) Patentinhaber: Grenzebach Maschinenbau GmbH, 86663 Asbach-Baeumenheim (DE)
(72) Erfinder: NIEWIERA, Wolfgang, 86609 Donauwörth (DE)
(74) Vertreter: Kindermann, Peter
(86) Internationale Anmeldenummer: PCT/DE2012/000355
(87) Internationale Veröffentlichungsnummer: WO 2012/136193

(56) Entgegenhaltungen:
- DE-B4- 10 237 478
- DE-C1- 19 847 549

## Beschreibung

Die Herstellung von Floatglas erfolgt meist durch das fortlaufende Ausgießen der Glasschmelze auf einem, in einer länglichen Wanne erhitzten, Zinnbad und das sich hieraus ergebende Glasband.
Das anschließende Konfektionieren von Floatglas geschieht durch Längsschneiden und Querschneiden des aus der Floatglasfertigung mit einer bestimmten Vorschubgeschwindigkeit laufenden Glasbandes. Das Längsschneiden bewirken hierbei in entsprechenden Positionen über dem Glasband stationierte Längsschneidräder. Das Querschneiden, oder Ablängen, erfolgt mit Hilfe von Schneidbrücken und daran quer über das Glasband bewegten Querschneidrädern. Die zu schneidenden Glasflächen werden üblicherweise aus Floatglas von einer Länge von 6 m und einer Breite von mehr als 3 m herausgeschnitten.

Bei der Formgebung des Glasbandes bildet sich aufgrund von Oberflächenspannungen, Temperaturgradienten und Viskositätsgradienten und infolge mechanischer Transportwerkzeuge, wie zum Beispiel Rollern, an den Rändern in der Regel eine etwas andere Dickenverteilung aus als in der Mitte, bzw. der späteren Netto - Nutzfläche. Der Randbereich zu beiden Seiten des Glasbandes wird dabei als Bortenbereich bezeichnet.
Der DE 102 37 478 B4 liegt deshalb die Aufgabe zugrunde, das übliche Verfahren zum Schneiden eines Glasbandes hinsichtlich der aufgebrachten Schneidkraft so zu führen, dass sowohl der Borten - als auch der Nettobereich ausreichend eingeritzt werden, um einen korrekten Bruchvorgang, und gleichzeitig ein vorzeitiges Zerbrechen des Glasbandes zu erreichen.
Gemäß des Anspruchs 1 dieser Druckschrift wird zur Lösung dieser Aufgabe von einem Verfahren zum Schneiden eines fortlaufenden Glasbandes bei der Herstellung von Flachglas ausgegangen, das über seine Breite eine inhomogene Dickenverteilung aufweist, bei dem ferner ein Schneidwerkzeug mit von einer Steuerung vorgegebener Schneidkraft unter Erzeugung eines Ritzes winkelig zur Laufrichtung über die Breite des Glasbandes bewegt und anschließend das Glasband entlang des Ritzes mechanisch gebrochen wird. Bei einem solchen Verfahren soll unter Schutz gestellt werden, dass die Schneidkraft angepasst an die Glasdicke aktiv von der Steuerung vorgegeben wird.

In einem anderen Bereich der Technik werden oft Gläser mit bestimmten optischen Funktionen zum Beispiel Gläser mit einer definierten präzisen Oberflächenstrukturierung gefordert. Eine solche Strukturierung wird unter anderem bei Displayscheiben von Flachbildschirmen, den so genannten Kanalplatten, gefordert.

Aus der DE 198 47 549 C1 ist zur Herstellung solcher Displayscheiben ein Formgebungswerkzeug mit strukturierter Oberfläche zum Erzeugen von Strukturen auf Glas und seine Verwendung bei der Strukturierung von Kanalplatten, bekannt. Dieses bekannte Formgebungswerkzeug weist einen Walzzylinder auf der aus einem metallischen Hohlzylinder besteht auf dessen Außenmantel ein formgebendes Blech, das mit Ausnehmungen entsprechende dem Negativ der aufzubringenden Glasstrukturen versehen ist, im innigen flächigen Kontakt aufgebracht ist. Des Weiteren weist dieses Werkzeug eine Welle zum kontinuierlichen Antrieb des Walzzylinders auf, die sich durch den metallischen Hohlzylinder hindurch erstreckt, wobei auf der Höhe der Stirnseite des metallischen Hohlzylinders zwei Mitnehmer auf der Welle fest angebracht sind, die formschlüssig mit dem Hohlzylinder im Wirkeingriff sind. Ferner weist das bekannte Werkzeug eine elektrische Heizung auf die elektrisch isoliert zwischen der Welle und dem metallischen Hohlzylinder angeordnet ist und eine zusätzliche thermische Isolierung zur Welle besitzt.

Mittlerweile gibt es weitere Möglichkeiten Glas mit strukturierter Oberfläche auf einer Floatglas - Linie herzustellen, für die jedoch kein druckschriftlicher Nachweis vorliegt.

Besteht nunmehr die Anforderung an ein und derselben Floatglas - Linie abwechselnd Glas mit einer glatten Oberfläche und Glas mit einer strukturierten Oberfläche zu produzieren und abzulängen, so sind bisher verschiedene Anlagen bei der Herstellung solcher unterschiedlicher Gläser erforderlich. Verwendet man in diesem Fall dagegen eine bestehende Anlage, so muss diese zum Beispiel bei der Umstellung von normalem Glas auf Glas mit einer strukturierten Oberfläche mit einer entsprechenden Zusatzeinrichtung versehen werden. Zudem muss die alte Glasschmelze erst abkühlen und dann der Schmelzvorgang erneut gestartet werden. Hinzu kommt, dass Glas mit einer strukturierten Oberfläche auf andere Art geschnitten werden muss als normales Float - Glas.

Der Erfindung liegt deshalb die Aufgabe zugrunde, eine Vorrichtung und ein diesbezügliches Verfahren anzugeben, die es ermöglichen ein Float - Glas - Band während des laufenden Betriebs unabhängig von der Struktur seiner Oberfläche abzulängen.

Diese Aufgabe wird durch die Vorrichtung nach Anspruch 1, bzw. das Verfahren nach Anspruch 6 gelöst.

Im Wesentlichen besteht diese Lösung darin, dass eine Vorrichtung zum Ablängen, bzw. Schneiden des Glasbandes oberhalb und gleichzeitig unterhalb vorgesehen ist.

Die erfindungsgemäße Vorrichtung wird im Folgenden näher beschrieben.

Es zeigen im Einzelnen:
Figur 1: eine Draufsicht auf eine erfindungsgemäße Vorrichtung
Figur 2: eine Seitenansicht der erfindungsgemäßen Vorrichtung
Figur 3: eine detaillierte Draufsicht auf die Laufschienen
Figur 4. eine detaillierte Seitenansicht der beiden Schneid - Bereiche
Figur 5: eine detaillierte Seitenansicht des Brechbereichs beider Schnittarten

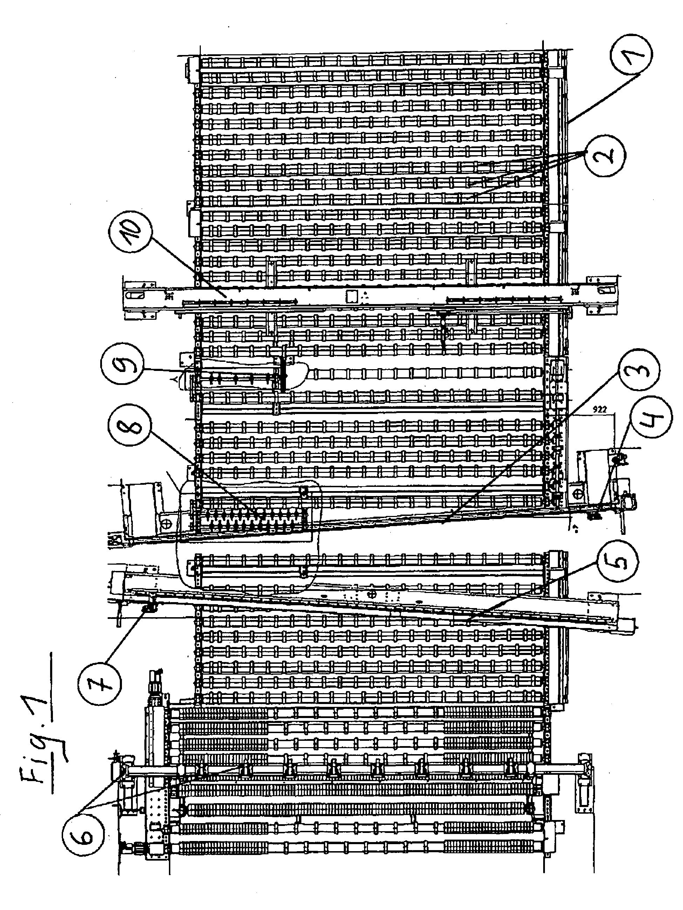

In der Fig. 1 ist eine Draufsicht auf eine erfindungsgemäße Vorrichtung gezeigt. Die Transportrollen 2 werden im Grundrahmen 1 gelagert, wobei das jeweilige Glasband 11 sich von der rechten Seite der Fig.1 der Messbrücke 10 nähert. Im rechten mittleren Bereich der gezeigten Draufsicht wird das strukturierte Floatglas mittels des in der Laufschiene 3 laufenden unteren Schneidschlittens 4 von unten geschnitten. Da bei diesem Vorgang, der entgegen der Schwerkraft erfolgt und das Glasband 11 anhebt, ein definierter Gegendruck benötigt wird, laufen auf der Oberseite des Glasbandes 11 mit dem Schneidschlitten 4 die gezeigten Gegendruckrollen 8 mit. Um einen rechtwinkelig verlaufenden Schnitt zu ermöglichen, verläuft die Laufschiene 3 schräg zur Laufrichtung des Glasbandes 11 um die Bewegung des Glasbandes 11 während des Schneidevorgangs zu kompensieren. Mittels eines seitlich angebrachten Messrades 9 werden die Geschwindigkeit und die Länge des abzuschneidenden Glasbandes 11 gemessen. Die so ermittelten Daten werden in der Messbrücke 10 verarbeitet und zur Steuerung des unteren Schneidschlittens 4 verwendet. Um einen gewünschten rechtwinkelig zur Laufrichtung des Glasbandes 11 verlaufenden Schnitt zu erreichen, muss bei einem sich schneller sich bewegenden Glasband 11 sich auch die Geschwindigkeit des Schneidschlittens 4 erhöhen, und umgekehrt. Da bei dem Schneidvorgang nicht nur die Geschwindigkeit des Schneidschlittens 4 sondern auch die Schrägstellung der Laufschiene 3 eine Rolle spielt, da sich die Schneide am jeweiligen Schneidschlitten nicht beliebig schnell bewegen kann, ist auch der Winkel den die Laufschiene 3 quer zur Laufrichtung des Glasbandes 11 bildet, an die Geschwindigkeit des Glasbandes 11 angepasst.
Die Gegendruckrollen 8 laufen hierbei über die strukturierte Oberfläche des Glasbandes 11. Da die Beschaffenheit der strukturierten Oberfläche stark schwanken kann, muss der Gegendruck der Gegendruckrollen 8 so erfolgen, dass diese nicht während des Rollvorgangs ein, durch die jeweilige Rautiefe der Struktur verursachtes, ratterndes Vibrieren des Glasbandes 11 verursachen und die Schneide, bzw. das Schneidrad, am Schneidschlitten 4 am zügigen und gleichmäßig tiefen Eingriff behindern. Denn durch ein solches ratterndes Vibrieren könnte der Schneidschlitten ebenfalls auf dem Glasband 11 vibrierend entlang fahren und einen glatten, durchgängig gleichtiefen, Schnitt verhindern. Deshalb sind die Gegendruckrollen 8 bevorzugt in der Art eines luftgefüllten Fahrzeugreifens aufgebaut. Die Gefahr eines ratternden Vibrierens wird mittels eines, die Rauhtiefe der Oberfläche des Glasbandes 11, ermittelnden Sensors nach Erfahrungswerten abgeschätzt und der Luftdruck der Gegendruckrollen 8 automatisch so eingestellt, dass der Schneidschlitten 4 sicher seine Funktion erfüllen kann. Auf diese Weise wird auch die Standzeit des Schnittrades des Schneidschlittens 4 erhöht.

Im linken Bereich der gezeigten Draufsicht, wird ein Glasband 11 im Falle einer unstrukturierten normalen Oberfläche von oben über den auf der Laufschiene 5 laufenden oberen Schneidschlitten 7 geschnitten.

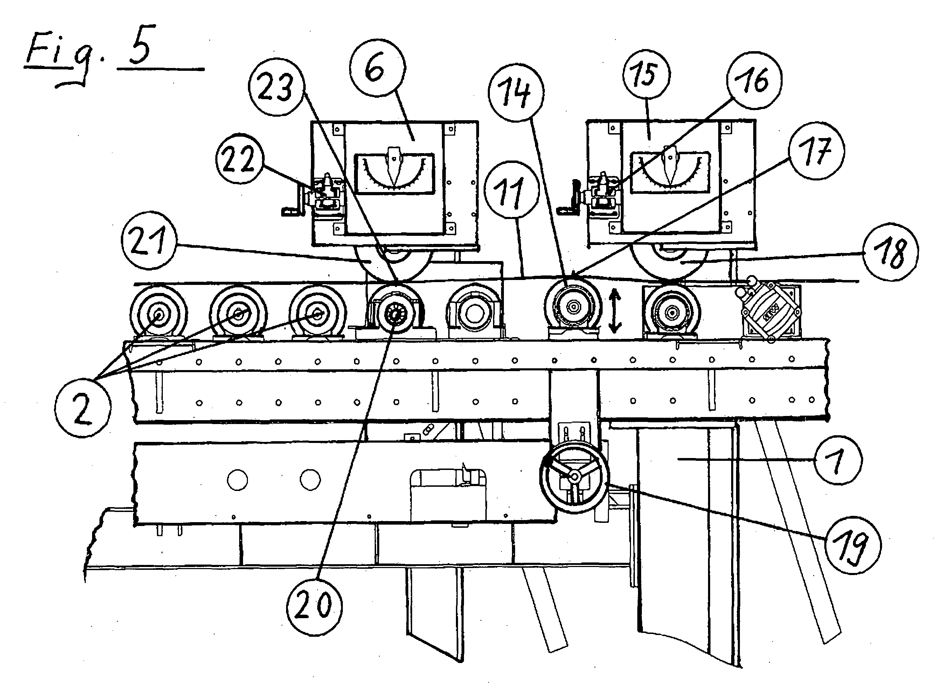

Die in der Fig. 1 zu erkennende Lücke zwischen beiden Schneidvorrichtungen ist aus Gründen der besseren Darstellung frei gelassen. Diese Lücke wird normalerweise mittels Transportrollen 2 überbrückt. Die unterschiedliche Neigung der Laufschienen 3 und 5 ist ebenfalls dieser Darstellung geschuldet. Auf diese Weise soll auch verdeutlicht werden, dass sich die Schrägstellung der Laufschienen 3 und 5 unterschiedlich voneinander verstellen lässt. Auf die Darstellung entsprechender Stellmotore bzw. Verstell - Anordnungen wurde aus Gründen der Übersichtlichkeit verzichtet.
Die im Ablauf folgende vordere Niederhaltung 6 stellt den Anschluss zu der Seitenansicht des Brechbereichs nach der Fig. 5 dar.

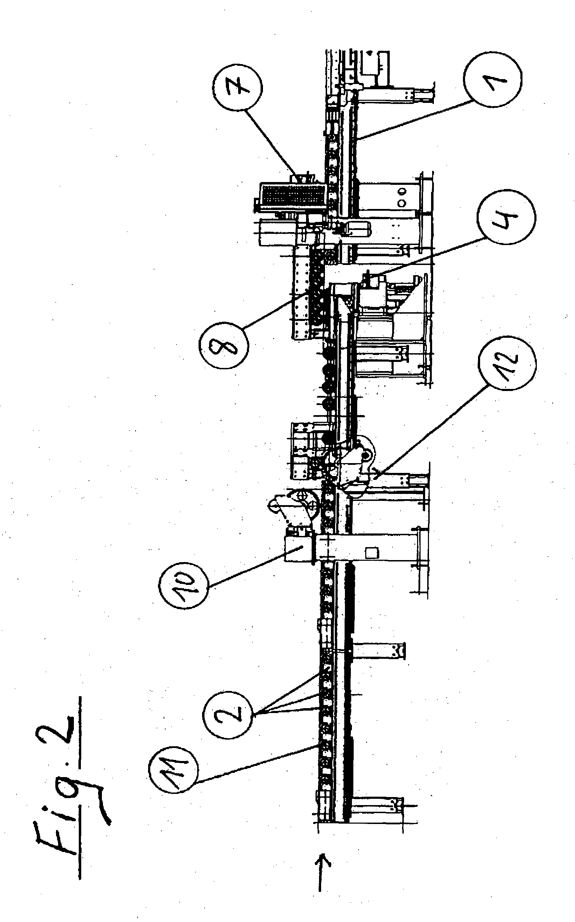

In der Fig. 2 ist eine Seitenansicht der erfindungsgemäßen Vorrichtung zu erkennen. Auf den Transportrollen 2 läuft hier das Glasband 11 von der linken Seite her in die Richtung des unteren Schneidschlittens 4 mit den ihm zugeordneten Gegendruckrollen 8. Stromabwärts folgt die Messbrücke 10. Anschließend folgt die Messeinrichtung 12, bei der im Falle des Vorliegens eines Floatglases mit strukturierter Oberfläche die Erfassung der relevanten Daten unterhalb der strukturierten Oberfläche erfolgt.
In dieser Darstellung ist ferner noch der mit dem Grundrahmen 1 verbundene obere Schneidschlitten 7 dargestellt.

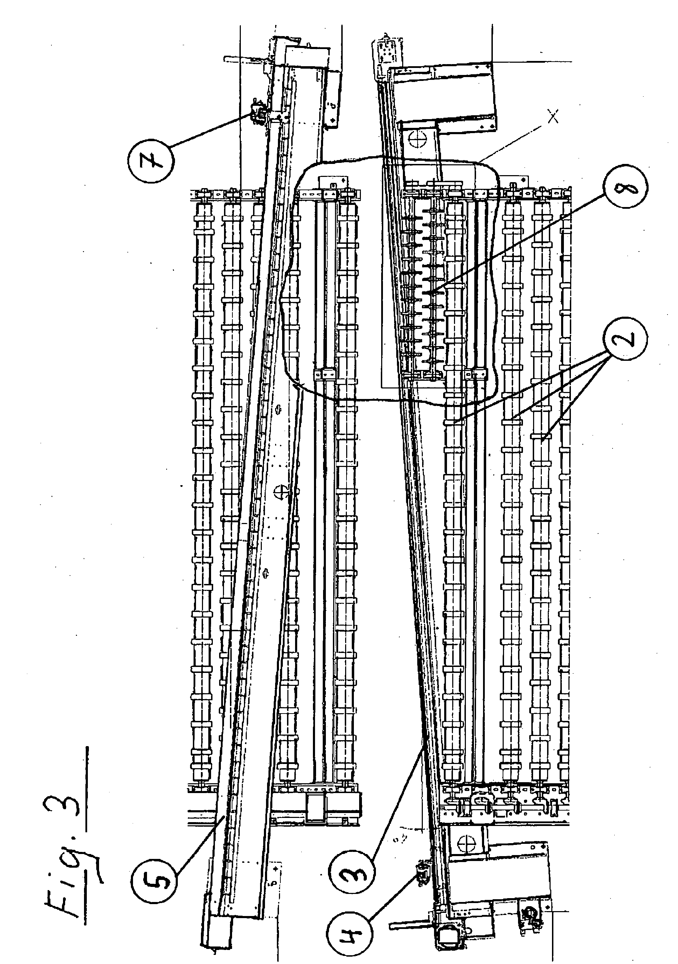

In der Fig.3 folgt eine detaillierte Draufsicht auf die Laufschienen wie sie in der Fig. 1 gezeigt sind. Von unten nach oben sind hier in der Flussrichtung des Glasbandes 11 die Transportrollen 2 und die Laufschiene 3 mit dem unteren Schneidschlitten 4 und seinen Gegendruckrollen 8 zu erkennen. Im oberen Bildbereich folgen die Laufschiene 5 und der zugehörige obere Schneidschlitten 7.

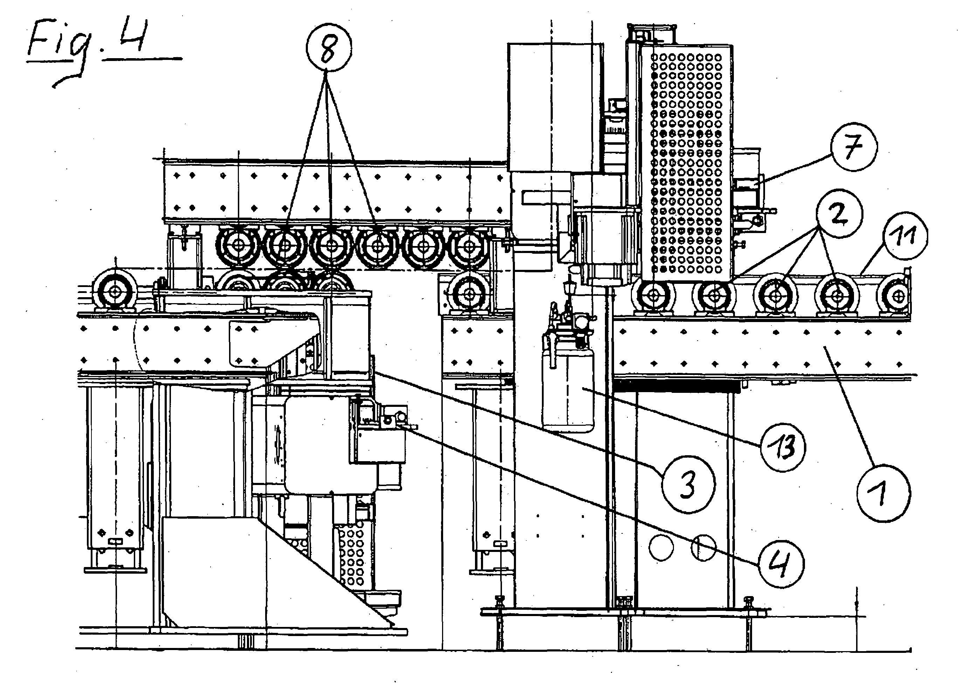

Die in der Fig. 4 gezeigte detaillierte Seitenansicht de beiden Schneid - Bereiche offenbart weitere nähere Einzelheiten. Die Flussrichtung des Glasbandes 11 ist hier von links nach rechts. Zusätzlich zu der unteren Laufschiene 3 mit dem unteren Schneidschlitten 4 und den sechs Gegendruckrollen 8 ist hier noch die Versorgungseinrichtung 13 zur Lieferung von Schneidöl zu erkennen. Auf der rechten Seite sind die Laufrollen 2 mit dem aufliegenden Glasband 11 und der obere Schneidschlitten 7 mit seiner Befestigung im Grundrahmen 1 größer herausgezeichnet.

Die Fig. 5 zeigt eine detaillierte Seitenansicht des Brechbereichs beider Schnittarten. Hier ist der Anschluss zu der Darstellung der Fig.1 über die vordere Niederhaltung 6 zu erkennen, die in der Fig.1 auf der linken Seite dargestellt ist und in der Fig. 5 ebenfalls auf der linken Seite erscheint, jedoch von der Seite in der Weise zu sehen ist, dass das Glasband 11 in Flussrichtung von links nach rechts läuft. In der Zusammenwirkung sind hier im oberen Bildbereich die vordere Niederhaltung 6 der Glasbrecheinheit und die hintere Niederhaltung 15 der Glasbrecheinheit zu sehen, wobei beide Niederhaltungen aus Darstellungsgründen etwas dichter zusammen gerückt gezeichnet sind als den räumlichen Verhältnissen in der Praxis entspricht. Die vordere Niederhaltung 6 besorgt hier mittels der vorderen Niederhaltewalze 21 im Verbund mit der Brechwalze 20 den Bruch des auf den Transportrollen 2 laufenden Glasbandes 11 an der Stelle eines Unterschnitts, wenn dieses eine strukturierte Oberfläche aufweist und vorher mittels des unteren Schneidschlittens 4 an der gewünschten Stelle angeschnitten wurde. Die entstehende Bruchstelle eines solchen Unterschnitts ist mit 23 bezeichnet. Die vordere Niederhaltewalze 21 drückt hierbei von oben auf die strukturierte Oberfläche, wie im Fall der Gegendruckrollen 8. Deshalb ist auch für die vordere Niederhaltewalze 21, ebenso vorzugsweise, eine Ausführung nach der Art eines luftgefüllten Fahrzeugsreifens vorgesehen, wie in der Fig.1 für die Gegendruckrollen 8 beschrieben.
Handelt es sich bei dem Glasband 11 um ein unstrukturiertes Floatglas verharrt die vordere Niederhaltewalze 21 in einer oberen Position, so dass sich das Glasband 11 ungestört in Richtung der Brechwalze 14 für einen Oberschnitt fortbewegen kann. Befindet sich dann das Glasband 11 an der Stelle 17 auf dem obersten Punkt der Brechwalze 14, tritt die hintere Niederhaltung 15 mittels der Niederhaltewalze 18 in Aktion und drückt in der Weise auf das Glasband 11, dass dieses an der gewünschten Stelle 17 abbricht. Der Weitertransport erfolgt in beiden Fällen über weitere, nicht gezeigte, Transportrollen 2 bis zu einer Weichenstelle, an der dann die abgeschnittenen Glasbänder 11 entsprechend ihrer unterschiedlichen Art sortiert werden.
Wie der Fig.5 zu entnehmen ist, existieren für die Niederhaltung 6, die Brechwalze 14 und die Niederhaltung 15 jeweils Möglichkeiten zur Feineinstellung mit den entsprechenden Bezeichnungen 22, 19 und 16.
Die genannten Feineinstellungen haben als Hauptparameter die Glasdicke eines Glasbandes 11, die Zusammensetzung der verwendeten Glasschmelze und, wenn vorhanden, die Art der Struktur zum Thema. In einer besonderen Ausgestaltung werden diese Parameter von entsprechenden Sensoren erfasst und mittels auf Erfahrungswerten oder errechneten Werten beruhenden Stellgrößen zur automatischen Feineinstellung 16,19 und / oder 22 verwendet.

Als Anwendungsgebiet für Floatgläser mit strukturierten Oberflächen wird vor allem auf Photovoltaik - Elemente verwiesen.
Die Steuerung der komplexen Bewegungsvorgänge und die Signalverarbeitung der verwendeten Sensoren erfordern ein spezielles Steuerungsprogramm.

### Bezugszeichenliste

- 1: Grundrahmen
- 2: Transportrollen
- 3: Laufschiene für unteren Schneidschlitten 4
- 4: unterer Schneidschlitten
- 5: Laufschiene für oberen Schneidschlitten 7
- 6: vordere Niederhaltung der Glasbrecheinheit
- 7: oberer Schneidschlitten
- 8: Gegendruckrollen für den unteren Schneidschlitten 4
- 9: Messrad (Längen und Geschwindigkeit)
- 10: Messbrücke
- 11: Glasband
- 12: untere Messeinrichtung
- 13: Versorgungseinrichtung für Schneidöl
- 14: Brechwalze für einen Oberschnitt
- 15: hintere Niederhaltung der Glasbrecheinheit
- 16: Feineinstellung der hinteren Niederhaltung 15
- 17: Bruchstelle eines Oberschnitts
- 18: hintere Niederhaltewalze
- 19: Feineinstellung der Brechwalze 14 für einen Oberschnitt
- 20: Brechwalze für einen Unterschnitt
- 21: vordere Niederhaltewalze
- 22: Feineinstellung der Niederhaltung 6
- 23: Bruchstelle eines Unterschnitts

## Patentansprüche

1. Vorrichtung zum Ablängen eines Float - Glas - Bandes mit normaler oder strukturierter Oberfläche mit den folgenden Merkmalen:
a) jeweils einem Schneidschlitten (4,7) mit einer unteren bzw. einer oberen Laufschiene (3,5) für einen Unterschnitt bei strukturierter Oberfläche, bzw. einen Oberschnitt bei normaler Oberfläche, wobei beide Laufschienen (3,5) in einem spitzen Winkel schräg zur Laufrichtung des Glasbandes (11) angeordnet sind und diese Schrägstellung einstellbar ist,
b) einer Anzahl von Gegendruckrollen (8) für den unteren Schneidschlitten (4),
c) einer Niederhaltung (6) mit einer Brechwalze (20) und einer vorderen Niederhaltewalze (21) für einen Unterschnitt,
d) einer Niederhaltung (15) mit einer Brechwalze (14) und einer hinteren Niederhaltewalze (18) für einen Oberschnitt,
e) Einrichtungen (10, 11, 12) zur Messung der Vorlaufgeschwindigkeit des Glasbandes (11) und seiner aktuellen Länge.

2. Vorrichtung nach Anspruch 1,
**dadurch gekennzeichnet**
**dass** Andruckräder (8, 21) die mit der strukturierten Oberfläche eines Glasbandes (11) in Berührung kommen nach der Art luftgefüllter Fahrzeugreifen ausgeführt sind, wobei der Luftdruck der Rauhtiefe der Struktur automatisch angepasst wird.

3. Vorrichtung nach einem der vorhergehenden Ansprüche,
**dadurch gekennzeichnet,**
**dass** die Einstellung der Schrägstellung der Laufschienen (3,5) in Abhängigkeit von der Vorlaufgeschwindigkeit des Glasbandes (11) erfolgt.

4. Vorrichtung nach einem der vorhergehenden Ansprüche,
**dadurch gekennzeichnet,**
**dass** die Niederhaltung (6) und / oder die Brechwalze (14) und /oder die Niederhaltung (15) jeweils Feineinstellungen aufweisen, die in Abhängigkeit von der Glasdicke des Glasbandes (11) und / oder der Zusammensetzung der Glasschmelze und / oder der Art der Struktur der Oberfläche des Glasbandes (11) als Parameter abhängen.

5. Vorrichtung nach Anspruch 4,
**dadurch gekennzeichnet,**
**dass** die genannten Parameter teilweise oder insgesamt von entsprechenden Sensoren erfasst und mittels, auf Erfahrungswerten oder errechneten Werten beruhenden, Stellgrößen zur automatischen Feineinstellung verwendet werden.

6. Verfahren zum Ablängen eines Float - Glas - Bandes mit normaler oder strukturierter Oberfläche mit den folgenden Merkmalen:
a) eine Anlage zur Herstellung von normalem Floatglas oder Floatglas mit strukturierter Oberfläche wird mit jeweils einem Schneidschlitten (4,7) mit einer unteren bzw. einer oberen Laufschiene (3,5) für einen Unterschnitt bei strukturierter Oberfläche, bzw. einen Oberschnitt bei normaler Oberfläche, wobei beide Laufschienen ( 3,5) in einem spitzen Winkel schräg zur Laufrichtung des Glasbandes (11) angeordnet sind und diese Schrägstellung einstellbar ist, ausgestattet,
b) es wird eine Anzahl von Gegendruckrollen (8) für den unteren Schneidschlitten (4) vorgesehen,
c) es wird eine Niederhaltung (6) mit einer Brechwalze (20) und einer vorderen Niederhaltewalze (21) für einen Unterschnitt vorgesehen,
d) es wird eine Niederhaltung (15) mit einer Brechwalze (14) und einer hinteren Niederhaltewalze (18) für einen Oberschnitt vorgesehen,
e) es werden Einrichtungen (10, 11, 12) zur Messung der Vorlaufgeschwindigkeit des Glasbandes (11) und seiner aktuellen Länge vorgesehen.

7. Verfahren nach Anspruch 6,
**dadurch gekennzeichnet,**
**dass** Andruckräder (8, 21) die mit der strukturierten Oberfläche eines Glasbandes (11) in Berührung kommen nach der Art luftgefüllter Fahrzeugreifen ausgeführt sind, wobei der Luftdruck der Rauhtiefe der Struktur automatisch angepasst wird.

8. Verfahren nach einem der Ansprüche 6 oder 7,
**dadurch gekennzeichnet,**
**dass** die Einstellung der Schrägstellung der Laufschienen (3,5) in Abhängigkeit von der Vorlaufgeschwindigkeit des Glasbandes (11) erfolgt.

9. Verfahren nach einem der Ansprüche 6 bis 8,
**dadurch gekennzeichnet,**
**dass** die Niederhaltung (6) und / oder die Brechwalze (14) und /oder die Niederhaltung (15) jeweils Feineinstellungen aufweisen, die in Abhängigkeit von der Glasdicke des Glasbandes (11) und / oder der Zusammensetzung der Glasschmelze und / oder der Art der Struktur der Oberfläche des Glasbandes (11) als Parameter abhängen.

10. Verfahren nach Anspruch 9,
**dadurch gekennzeichnet,**
**dass** die genannten Parameter teilweise oder insgesamt von entsprechenden Sensoren erfasst und mittels auf Erfahrungswerten oder errechneten Werten beruhenden Stellgrößen zur automatischen Feineinstellung verwendet werden.

11. Verfahren nach einem der Ansprüche 6 bis 10,
**dadurch gekennzeichnet,**
**dass** als Anwendungsgebiet für Floatgläser mit strukturierten Oberflächen Photovoltaik - Elemente eingesetzt werden.

12. Computerprogramm mit einem Programmcode zur Durchführung der Verfahrensschritte nach einem der Ansprüche 6 bis 11 wenn das Programm in einem Computer ausgeführt wird.

13. Maschinenlesbarer Träger mit dem Programmcode eines Computerprogramms zur Durchführung des Verfahrens nach einem der Ansprüche 6 bis 11, wenn das Programm in einem Computer ausgeführt wird.

## Claims

1. Device for cutting to length a float glass strip having a normal or structured surface, having the following features:
a) in each case a cutting carriage (4, 7) having a lower or an upper running rail (3, 5) for an undercut in the case of a structured surface, or an overcut in the case of a normal surface, wherein both running rails (3, 5) are arranged obliquely at an acute angle in relation to the conveying direction of the glass strip (11) and this inclination is adjustable,
b) a number of counterpressure rollers (8) for the lower cutting carriage (4),
c) a hold-down unit (6) having a fracture roller (20) and a front hold-down roller (21) for an undercut,
d) a hold-down unit (15) having a fracture roller (14) and a rear hold-down roller (18) for an overcut,
e) units (10, 11, 12) for measuring the advancing speed of the glass strip (11) and its current length.

2. Device according to Claim 1,
**characterized in**
**that** pressure wheels (8, 21) which come into contact with the structured surface of a glass strip (11) are configured in the manner of pneumatic vehicle tires, the air pressure being automatically adjusted to the depth of the roughness of the structure.

3. Device according to one of the preceding claims,
**characterized in**
**that** the adjustment of the inclination of the running rails (3, 5) takes place depending on the advancing speed of the glass strip (11).

4. Device according to one of the preceding claims,
**characterized in**
**that** the hold-down unit (6) and/or the fracture roller (14) and/or the hold-down unit (15) in each case have fine adjustments which depend on the glass thickness of the glass strip (11) and/or the composition of the molten glass and/or the type of structure of the surface of the glass strip (11) as parameters.

5. Device according to Claim 4,
**characterized in**
**that** the mentioned parameters in part or collectively are detected by corresponding sensors and by means of set point values, which are based on experience values or calculated values, are used for the automatic fine adjustment.

6. Method for cutting to length a float glass strip having a normal or structured surface, having the following features:
a) an installation for manufacturing normal float glass or float glass having a structured surface is equipped with in each case a cutting carriage (4, 7) having a lower or an upper running rail (3, 5) for an undercut in the case of a structured surface, or an overcut in the case of a normal surface, wherein both running rails (3, 5) are arranged obliquely at an acute angle in relation to the conveying direction of the glass strip (11) and this inclination is adjustable,
b) a number of counterpressure rollers (8) for the lower cutting carriage (4) are provided,
c) a hold-down unit (6) having a fracture roller (20) and a front hold-down roller (21) for an undercut is provided,
d) a hold-down unit (15) having a fracture roller (14) and a rear hold-down roller (18) for an overcut is provided,
e) units (10, 11, 12) for measuring the advancing speed of the glass strip (11) and its current length are provided.

7. Method according to Claim 6,
**characterized in**
**that** pressure wheels (8, 21) which come into contact with the structured surface of a glass strip (11) are configured in the manner of pneumatic vehicle tires, the air pressure being automatically adjusted to the depth of the roughness of the structure.

8. Method according to either of Claims 6 and 7,
**characterized in**
**that** the adjustment of the inclination of the running rails (3, 5) takes place depending on the advancing speed of the glass strip (11).

9. Method according to one of Claims 6 to 8,
**characterized in**
**that** the hold-down unit (6) and/or the fracture roller (14) and/or the hold-down unit (15) in each case have fine adjustments which depend on the glass thickness of the glass strip (11) and/or the composition of the molten glass and/or the type of structure of the surface of the glass strip (11) as parameters.

10. Method according to Claim 9,
**characterized in**
**that** the mentioned parameters in part or collectively are detected by corresponding sensors and by means of set point values, which are based on experience values or calculated values, are used for the automatic fine adjustment.

11. Method according to one of Claims 6 to 10,
**characterized in**
**that** photovoltaic elements are used as the field of application for float glass panels having structured surfaces.

12. Computer program having a program code for
carrying out the method steps according to one of Claims 6 to 11 in the event that the program is executed in a computer.

13. Machine-readable carrier having the program
code of a computer program for carrying out the method according to one of Claims 6 to 11 in the event that the program is executed in a computer.

## Revendications

1. Dispositif de découpe à longueur d'une bande en verre flotté possédant une surface normale ou structurée, qui présente les caractéristiques suivantes :
a) respectivement un chariot de coupe (4, 7) comprenant une glissière inférieure ou supérieure (3, 5) pour une coupe par le dessous dans le cas d'une surface structurée ou une coupe par le dessus dans le cas d'une surface normale, les deux glissières (3, 5) étant disposées selon un angle aigu de manière oblique par rapport au sens de défilement de la bande en verre (11) et cette position oblique étant réglable,
b) une pluralité de galets contre-presseurs (8) pour le chariot de coupe inférieur (4),
c) un dispositif serre-flanc (6) muni d'un rouleau briseur (20) et d'un rouleau serre-flanc avant (21) pour une coupe par le dessous,
d) un dispositif serre-flanc (15) muni d'un rouleau briseur (14) et d'un rouleau serre-flanc arrière (18) pour une coupe par le dessus,
e) des dispositifs (10, 11, 12) pour mesurer la vitesse d'avance de la bande en verre (11) et sa longueur actuelle.

2. Dispositif selon la revendication 1, **caractérisé en ce que** des roues de pressage (8, 21) qui viennent en contact avec la surface structurée d'une bande en verre (11) sont réalisées sous la forme de pneus de véhicule remplis d'air, la pression d'air étant adaptée automatiquement à la profondeur de rugosité de la structure.

3. Dispositif selon l'une des revendications précédentes, **caractérisé en ce que** le réglage de la position oblique des glissières (3, 5) s'effectue en fonction de la vitesse d'avance de la bande en verre (11).

4. Dispositif selon l'une des revendications précédentes, **caractérisé en ce que** le dispositif serre-flanc (6) et/ou le rouleau briseur (14) et/ou le dispositif serre-flanc (15) présentent respectivement des réglages fins qui dépendent de l'épaisseur du verre de la bande en verre (11) et/ou de la composition de la masse fondue de verre et/ou de la nature de la structure de la surface de la bande en verre (11) en tant que paramètres.

5. Dispositif selon la revendication 4, **caractérisé en ce que** lesdits paramètres sont acquis partiellement ou en totalité par des capteurs correspondants et sont utilisés au moyen de grandeurs de commande s'appuyant sur des valeurs empiriques ou des valeurs calculées en vue du réglage fin automatique.

6. Procédé de découpe à longueur d'une bande en verre flotté possédant une surface normale ou structurée, qui présente les caractéristiques suivantes :
a) un système destiné à la fabrication de verre flotté normal ou de verre flotté doté d'une surface structurée est équipé respectivement d'un chariot de coupe (4, 7) comprenant une glissière inférieure ou supérieure (3, 5) pour une coupe par le dessous dans le cas d'une surface structurée ou une coupe par le dessus dans le cas d'une surface normale, les deux glissières (3, 5) étant disposées selon un angle aigu de manière oblique par rapport au sens de défilement de la bande en verre (11) et cette position oblique étant réglable,
b) une pluralité de galets contre-presseurs (8) est prévue pour le chariot de coupe inférieur (4),
c) un dispositif serre-flanc (6) muni d'un rouleau briseur (20) et d'un rouleau serre-flanc avant (21) est prévu pour une coupe par le dessous,
d) un dispositif serre-flanc (15) muni d'un rouleau briseur (14) et d'un rouleau serre-flanc arrière (18) est prévu pour une coupe par le dessus,
e) des dispositifs (10, 11, 12) sont prévus pour mesurer la vitesse d'avance de la bande en verre (11) et sa longueur actuelle.

7. Procédé selon la revendication 6, **caractérisé en ce que** des roues de pressage (8, 21) qui viennent en contact avec la surface structurée d'une bande en verre (11) sont réalisées sous la forme de pneus de véhicule remplis d'air, la pression d'air étant adaptée automatiquement à la profondeur de rugosité de la structure.

8. Procédé selon l'une des revendications 6 ou 7, **caractérisé en ce que** le réglage de la position oblique des glissières (3, 5) s'effectue en fonction de la vitesse d'avance de la bande en verre (11).

9. Procédé selon l'une des revendications 6 à 8, **caractérisé en ce que** le dispositif serre-flanc (6) et/ou le rouleau briseur (14) et/ou le dispositif serre-flanc (15) présentent respectivement des réglages fins qui dépendent de l'épaisseur du verre de la bande en verre (11) et/ou de la composition de la masse fondue de verre et/ou de la nature de la structure de la surface de la bande en verre (11) en tant que paramètres.

10. Procédé selon la revendication 9, **caractérisé en ce que** lesdits paramètres sont acquis partiellement ou en totalité par des capteurs correspondants et sont utilisés au moyen de grandeurs de commande s'appuyant sur des valeurs empiriques ou des valeurs calculées en vue du réglage fin automatique.

11. Procédé selon l'une des revendications 6 à 10, **caractérisé en ce que** des éléments photovoltaïques sont utilisés comme domaine d'applications pour des verres flottés possédant des surfaces structurées.

12. Programme informatique comprenant un code de programme destiné à mettre en oeuvre les étapes du procédé selon l'une des revendications 6 à 11 lorsque le programme est exécuté sur un ordinateur.

13. Support lisible par machine comprenant le code de programme d'un programme informatique destiné à mettre en oeuvre le procédé selon l'une des revendications 6 à 11 lorsque le programme est exécuté sur un ordinateur.
